# EUROPEAN PATENT APPLICATION

(11) **EP 3 392 789 A1**
(43) Date of publication of application: **24.10.2018**
(21) Application number: 18168550.4
(22) Date of filing: 20.04.2018
(51) Int. Cl.: G06F 17/50

(54) **DIGITAL DOUBLE PLATFORM**

(30) Priority: 21.04.2017 US 201762488265 P
(71) Applicant: Accenture Global Solutions Limited, Dublin 4 (IE)
(72) Inventor: WEBB, Sunny, San Francisco, California 94107 (US); DOOLEY, Robert, Dublin, California 94568 (US); SHORT, Matthew Thomas, San Jose, California 95126 (US); CHENG, Grace T., Mountain View, California 94043 (US)
(74) Representative: Swindell & Pearson Limited

(57) **Abstract**

Methods and systems for creating digital representations of real world objects that are connected back to real world objects, creating a digital double. In some aspects a method includes the actions of receiving sensor data from a real world object; receiving data representing a digital version of the real world object; and performing a virtual reality simulation displaying (i) a representation of at least some of the sensor data, and (ii) the digital version of the real world object. Performing a virtual reality simulation using (i) the sensor data, and (ii) the data representing the digital version of the real world object can include overlaying a visual representation of the sensor data on a visual representation of the digital version of the real world object. The method can further include determining one or more modifications to the real world object based on the performed virtual reality simulation.

## Description

### CROSS-REFERENCE TO RELATED APPLICATIONS

This application claims the benefit under 35 U.S.C. § 119(e) of the filing date of U.S. Patent Application No. 62/488,265, for "Digital Double Platform" which was filed on April 21, 2017, and which is incorporated here by reference.

### TECHNICAL FIELD

This specification relates to the fields of virtual reality, mixed reality, augmented reality, product engineering and manufacturing, and others discussed below.

### BACKGROUND

Automotive, aerospace, ground transportation equipment and other industries use virtual reality technologies as part of product engineering and manufacturing engineering. For example, virtual reality technology can be used to enable engineers from different disciplines to view and test current product designs - sometimes prior to the availability of any physical prototypes. Within a virtual reality environment, products can be viewed from multiple angles and properties of products can be tested through computational or physical simulations.

### SUMMARY

This specification describes systems and methods for applying immersive technology to a product development and manufacturing process or a simulation process. Innovative aspects of the subject matter described in this specification may be embodied in methods that include the actions of receiving sensor data from a real world object; receiving data representing a digital version of the real world object; and performing a virtual reality simulation displaying (i) a representation of at least some of the sensor data, and (ii) the digital version of the real world object.

Other embodiments of this aspect include corresponding computer systems, apparatus, and computer programs recorded on one or more computer storage devices, each configured to perform the actions of the methods. A system of one or more computers can be configured to perform particular operations or actions by virtue of having software, firmware, hardware, or a combination thereof installed on the system that in operation causes or cause the system to perform the actions. One or more computer programs can be configured to perform particular operations or actions by virtue of including instructions that, when executed by data processing apparatus, cause the apparatus to perform the actions.

The foregoing and other embodiments can each optionally include one or more of the following features, alone or in combination. In some implementations the sensor data comprises data from one or more sensors positioned on the real world object.

In some implementations the sensors comprise one or more of pressure, temperature, motion sensors.

In some implementations the sensor data comprises dynamic data collected during a physical simulation using the real world object.

In some implementations the physical simulation comprises an interactive virtual reality or mixed reality simulation.

In some implementations the digital version of the real world object comprises a three-dimensional image of the object.

In some implementations the three-dimensional image comprises a polygonal three-dimensional image.

In some implementations performing a virtual reality simulation using (i) the sensor data, and (ii) the data representing the digital version of the real world object comprises overlaying a visual representation of some or all of the sensor data on a visual representation of the digital version of the real world object.

In some implementations the visual representation of some or all of the sensor data comprises one or more of (i) a graphical representation, and (ii) a colour representation of some or all of the sensor data.

In some implementations overlaying a visual representation of some or all of the sensor data on a visual representation of the digital version of the real world object comprises overlaying a visual representation of sensor data from sensors of a given type on a visual representation of the digital version of the real world object.

In some implementations the method further comprises determining one or more modifications to the real world object based on the performed virtual reality simulation.

In some implementations the method further comprises aggregating sensor data from a first real world object and a second real world object; and performing a virtual reality simulation using (i) some or all of the aggregated sensor data, and (ii) the data representing the digital version of the real world object.

In some implementations performing the virtual reality simulation further comprises displaying the digital version of the real world object in the same field of view as the real world object itself or another recording of the real world object.

In some implementations the data representing a digital version of the real world object comprises data generated using crowd guided assistance.

The subject matter described in this specification can be implemented in particular embodiments so as to realize one or more of the following advantages. In some cases, a digital double platform, as described in this specification, may improve a product development process. For example, the product development process may take less time, e.g., due to the automation of converting computer-aided design (CAD) files to alternative, digital formats that are suitable for three-dimensional viewing in a virtual reality or mixed reality environment. As another example, the product development process may be more efficient and effective, e.g., due to the generation of three-dimensional visualizations of data in the real world and by relating quantitative numbers to qualitative experiences.

In some cases, a digital double platform, as described in this specification, may be used as part of a driving simulation process and provide improved testing and training of drivers. Improved testing and training can increase road safety, and can be used to design and evaluate new vehicles or advanced driver assistance systems.

Furthermore, a digital double platform could be used to remotely control the physical setup of what it represents. For example, a digital double car can be used to control an actual car remotely.

The details of one or more embodiments of the subject matter described in this specification are set forth in the accompanying drawings and the description below. Other potential features, aspects, and advantages of the subject matter will become apparent from the description, the drawings, and the claims.

### DESCRIPTION OF DRAWINGS

FIG. 1 shows a block diagram of an example digital double platform.
FIG. 2 shows a block diagram of an example computer-aided design (CAD) conversion pipeline.
FIG. 3 is a flowchart of an example process for performing a virtual reality simulation.
FIG. 4 illustrates an example virtual reality simulation.
FIG. 5 is a flowchart of an example process for converting the format of a computer-aided design (CAD) file.

Like reference symbols in the various drawings indicate like elements.

### DETAILED DESCRIPTION

This specification describes using immersive technology, e.g., virtual reality, mixed reality, and augmented reality, to assist in product development and manufacturing or simulation processes. In particular, immersive technology is used to test products and to provide an improved understanding of how people use products. In some implementations immersive technology may be further combined with crowd technology, e.g., a crowd assistance platform, to assist in product development.

A product development process may be described as including three stages, namely (i) crowd design, (ii) content conversion, and (iii) asset creation, internet of things (IoT) visualization and data processing. During a crowd design stage, a crowd of experts, e.g., engineers, may gather and verify product ideas. In particular, a crowd assistance platform may enable the crowd of experts to verify engineering, manufacturing and operations processes. For example, a designer or worker can submit a request, e.g., to verify, modify or optimize a product design, to the crowed assistance platform together with technical specifications, images, computer simulations and voice recordings. Experts can respond to the request in real time. The crowd assistance platform may improve the speed and efficiency of product design and development, since products can be developed and tested faster relative to traditional, internal design and verification processes.

Often, product designs are created, modified, analyzed and/or optimized using computer aided design (CAD) software installed on a computing system. For example, engineers typically design products, e.g., cars or planes, using CAD software. CAD software enables product engineers to improve the quality of a design of a product, document the design process of a product, and create a database for manufacturing the product. However, typically CAD outputs take the form of electronic files with a specific format, e.g., a format suitable for printing or machining. In some cases this specific format is not compatible with immersive technology computer systems, e.g., that rely on polygonal models as opposed to parametric/mathematical models. During a content conversion stage of a product development process, files created using computer-aided design (CAD) software are converted to an alternative format that can be visualized or rendered using VR/MR software.

An example innovative aspect described in this specification includes a CAD conversion pipeline that translates CAD design files into a format suitable for immersive technology computer systems, e.g., a format suitable for three-dimensional viewing in VR or MR systems. The pipeline is able to convert CAD files quickly and in mass, thus improving the efficiency of the product design and development process. VR and MR designers/product builders are provided with a "single source of truth" from a CAD file that may be used to create different models or simulations of a product using different applications. VR and MR product builders and designers can view and implement changes to a product design in a holographic digital twin, not just within the CAD software environment. As an example, a product designer may use the CAD conversion pipeline to show a pilot a new design of an airplane cockpit and to let the pilot explore and test drive the airplane. In some cases the CAD conversion pipeline incorporates feedback from a crowd of experts and processing of CAD files to further enhance the product design and development process.

During an asset creation stage, IOT visualization and data processing stage, a physical product may be created and set up with IOT sensors. Data can be taken from the sensors and digitalized on product designs/models that have be created using a CAD conversion process or other file conversion techniques. The digitalized data can be visualized and analyzed using immersive technology, e.g., MR/VR/AR, to provide further insights and information to assist in the produce development process.

An example innovative aspect described in this specification includes a platform for running analytics, models, and tests on digital representations (holograms or 3D art) of physical objects. As a specific example, the platform may be used to analyze, model and test a car seat under development. Once a prototype car seat has been manufactured, various sensors, e.g., pressure, heat or motion sensors, can be placed on the car seat. A user can utilize the seat within a VR/MR environment. For example, a user may sit in the seat and simulate driving through a busy town. During the simulation, the various sensors gather sensor data. The gathered sensor data is provided to the digital double platform for processing. Processing can include using some or all of the data, e.g., pressure sensor data, to generate a dynamic visualization of the car seat and data, e.g., a visualization of the pressure points of the user as he/she drove through the busy town. The dynamic visualization may be used to modify/optimize the design of the car seat. For example, if the dynamic visualization shows that the user continually places more pressure on one side of the car seat, even when driving in straight lines on level roads, the car seat design may be altered to correct this deficiency. In some cases feedback components for collecting feedback from a crowd of experts can be included.

As another specific example, the platform may be used to analyze model and test a person's driving skills and behavior. Various sensors can be placed in a driving simulator. A user can utilize a driver's seat in the driver simulator within a WR/MR environment. For example, the user may simulate driving at high speed or in poor weather conditions. During the simulation, the various sensors gather sensor data. The gathered sensor data is provided to the digital double platform for processing. Processing can include using some or all of the data, e.g., pressure sensor data, to generate a dynamic visualization of the driving simulator, e.g., a visualization of the pressure points of the user on the car sear, gear stick or steering wheel as they he/she drove. The dynamic visualization may be used to generate feedback data indicating how the user can improve their driving.

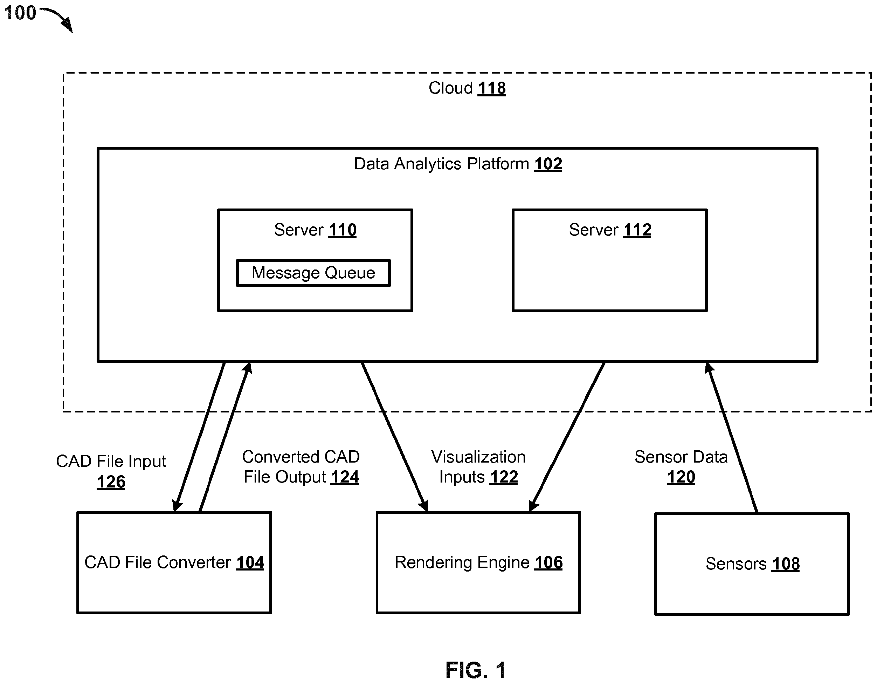

FIG. 1 shows a block diagram of an example digital double platform 100. The digital double platform 100 is an example of a system implemented as computer programs on one or more computing devices in one or more locations, in which the systems, components, and techniques described below can be implemented.

The digital double platform 100 is configured to perform tasks such as crowd-verified engineering, visualizations of software simulation activities, spatial visualizations with IoT connectivity, and aggregated analytics of real-time automation. The digital double platform 100 may be applied to a wide area of use cases including but not limited to product engineering, manufacturing, assembly, and operation activities.

The digital double platform 100 includes a data analytics platform 102. The data analytics platform 102 may include one or more servers, e.g., server 110 and server 112. One or more of the servers may include a message queue service. If one process in a decoupled system fails to process messages from the queue, other messages can still be added to the queue and be processed when the system has recovered. In some implementations the data analytics platform 102 may operate in a cloud computing environment 118. The digital double platform 100 further includes a computer-aided design (CAD) file converter 104, a rendering engine 106 and one or more sensors 108. The data analytics platform 102 is in data communication with each of the CAD file converter 104, rendering engine 106 and one or more sensors 108, e.g., through a communication network such as a local area network or wide area network.

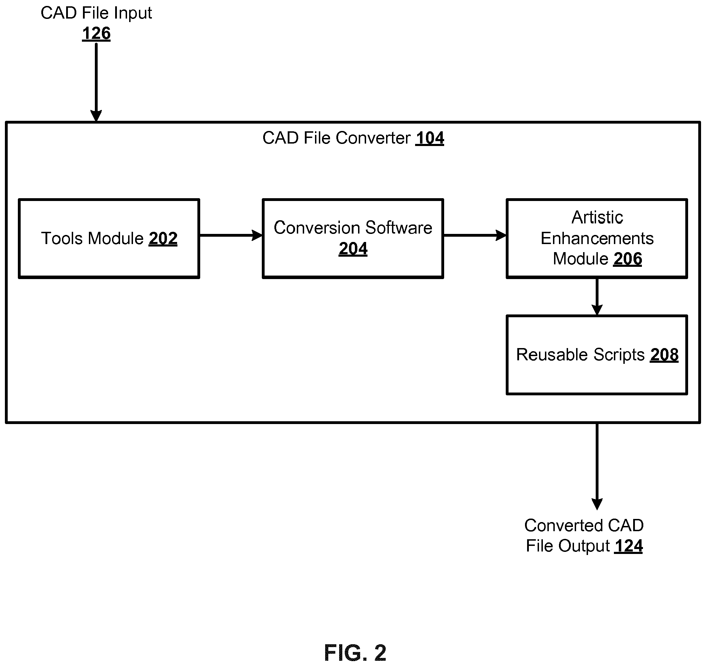

The CAD file converter 104 is configured to receive CAD files, e.g., CAD files 126, from the data analytics platform 102. For example, the CAD file converter 104 may receive a CAD file representing a three-dimensional model of a real world object, e.g., a driver seat of an automobile. The CAD file converter 104 is further configured to process received CAD files to generate converted CAD files, e.g., converted CAD files 124, and to provide the converted CAD files to the data analytics platform 102. The converted CAD files may include digital files that may be visualized in three dimensions using virtual reality or mixed reality hardware or software, e.g., installed on the rendering engine 106. For example, the converted CAD file may be used to generate a digital version of the real world object, e.g., a three dimensional image or hologram of the driver seat of the automobile. An example CAD file converter 104 is described in more detail below with reference to FIG. 2.

The one or more sensors 108 may include but are not limited to pressure sensors, motion sensors, temperature sensors, light sensors, force sensing resistors, tactile sensors, flow measurement devices, chemical sensors, or altitude sensors. In some implementations the sensors may be IoT sensors. The one or more sensors 108 may be embedded in or positioned on a real world object and used to collect sensor data. For example, the one or more sensors 108 may be positioned on a real world object that is to undergo a physical simulation. During the physical simulation, the sensors may collect dynamic sensor data representing detected changes or properties of the real world object during the physical simulation. The collected sensor data, e.g., sensor data 120, may be provided to the data analytics platform 102 for processing.

The data analytics platform 102 is configured to receive collected sensor data, e.g., sensor data 120, and to analyze the sensor data. In some implementations analyzing the sensor data may include aggregating sensor data collected from multiple real world objects. Analyzing the sensor data may include determining one or more visual representations of the sensor data. For example, the data analytics platform 102 may analyze sensor data from a particular type of sensors and determine a graphical representation of the sensor data, e.g., a bar chart showing locations of the sensor and data signal strength at respective sensor locations. The data analytics platform 102 may provide data representing the visual representations, e.g., visualization inputs 122, as input to the rendering engine 106.

The rendering engine 106 is configured to receive visualization inputs, e.g., visualization inputs 122, from the data analytics platform 102. As described above, the visualization inputs may include inputs generated from converted CAD files, e.g., converted CAD files 124, and inputs generated from sensor data, e.g., generated visual representations of sensor data.

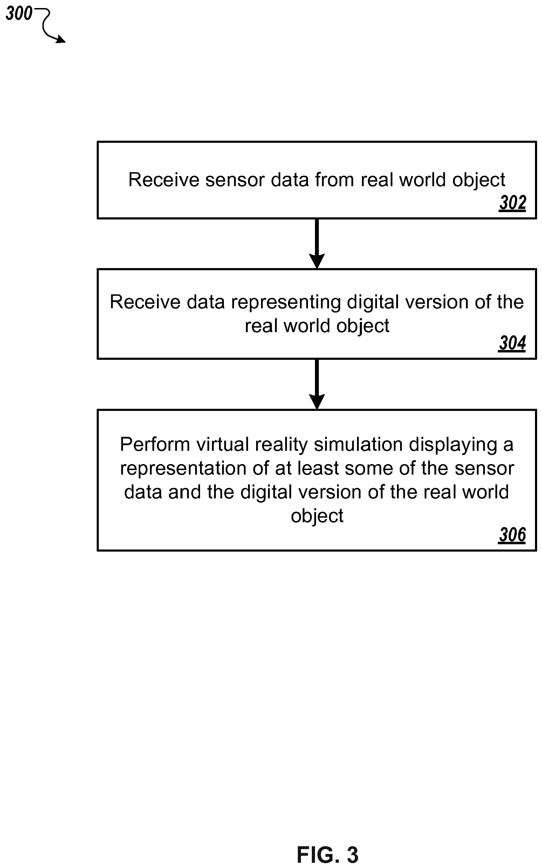

The rendering engine 106 is configured to process the received visualization inputs to generate, as output, a corresponding virtual reality simulation. For example, the rendering engine 106 may be configured to receive visualization inputs representing a digital version of a real world object, e.g., a digital version of a driver seat, and visual inputs representing a visual representation of sensor data collected during a physical simulation using the real world object, e.g., sensor data collected during a physical simulation using the driver seat. The rendering engine 106 may process the received visualization inputs to perform a virtual reality simulation displaying at least some of the visualization inputs. For example, the virtual reality simulation may include a simulation that overlays a visual representation of some or all of the sensor data 120 on a visual representation of the digital version of the real world object. An example process for performing a virtual reality simulation using a digital double platform 100 is described in more detail below with reference to FIG. 3.

In some implementations the digital double platform 100 may include or be connected to a crowd assistance platform. The crowd assistance platform may provide crowd guided assistance to a product manufacturing process. Remote workers can use the crowd assistance platform to verify engineering, manufacturing and operations processes by interfacing with distributed crowd experts. The workers can share requests, technical specifications, images and voice requests to the crowd assistance platform, and crowd experts can respond in real time.

FIG. 2 shows a block diagram of an example CAD file converter 104. The CAD file converter 104 is an example of a system implemented as computer programs on one or more computing devices in one or more locations, in which the systems, components, and techniques described below can be implemented.

The CAD file converter 104 includes a tools module 202, conversion software 204, artistic enhancements module 206 and reusable scripts 208. The components of the CAD file converter 104 may be in data communication with each other, e.g., through a communication network such as a local area network or wide area network. In some implementations the CAD file converter 104 may further include or otherwise be in data communication with a task management system.

The CAD file converter 104 is configured to receive a data representing a CAD file as input, e.g., CAD file input 126. The CAD file converter 104 may process the received input to generate data representing a converted CAD file as output, e.g., converted CAD file 124. The CAD file input may include data representing an object, e.g., a real world object such as all or part of an automobile or airplane. Typically, the representation of the object includes a parametric model of the object. The converted CAD file output may include data representing the object, including a digital representation of the object, e.g., a representation of the object that is suitable to be displayed using immersive technology.

A user may invoke the tools module 202 to augment and/or select all or a portion of the CAD file input 126. In addition, a user can provide additional conversion instructions via the tools module. The conversion software 204 is configured to convert received CAD files, e.g., in accordance with input received from the tools module 202, into alternative formats. For example, the conversion software 204 may include software that processes parametric or mathematical models of objects to an alternative format, e.g., digital files representing polygonal representations of objects. In some implementations the conversion software 204 may include 3D computer graphics software fir automatic 3D optimization, e.g., simplygon or an alternative open source tool. The type of conversion software 204 used to convert a received CAD file into an alternative format is dependent on a variety of factors, including but not limited to a complexity of the CAD file, e.g., a number of parameters included in the parametric model, a desired quality of the converted CAD file, or a desired conversion speed.

The artistic enhancements module 206 is configured to receive converted CAD files, e.g., including polygonal representations of objects, and to process the converted CAD files to generate digital images of the objects. In some implementations processing a converted CAD file may include altering data in the file to enhance a digital image represented by the file. For example, an artist may process the converted CAD file to make the digital image represented by the file appear more realistic or generally pleasing to the eye.

In some implementations the artistic enhancements module 206 may be in data communication with a task management system. The task management system (not illustrated) can be separate to the CAD file converter 104, however in some implementations the task management system may be included in the CAD file converter 104.

The task management system is configured to receive a request to process a file including a polygonal representation of an object, and to automatically route the received file to an available artist for processing. For example, the task management system may include a routing system that is configured to analyze a received request to determine one or more properties associated with the request, e.g., a type of object represented by the converted CAD file, a quality of the image of the object included in the converted CAD file, or a target processing time for processing the converted CAD file. The routing system may then determine which of multiple artists is the most appropriate to provide the request to. For example, the routing system may determine that converted CAD files relating to the automotive industry should ideally be routed to artist A, whereas converted CAD files relating to the aerospace industry should be routed to artist B. As another example, the routing system may determine that artist C has shown particular skill at creating high quality representations of objects from a converted CAD file, but that they take more time than artist D. In a time sensitive setting, the routing system may therefore determine to provide the request to artist D.

The reusable scripts module 208 is configured to improve the functionality of converted, enhanced CAD files. For example, the reusable scripts module 208 may be configured to add additional functionalities to received converted processed CAD files. Example functionalities include a manipulation functionality that allows a viewer of a digital representation of an object generated by a converted CAD file to rotate and zoom in, or an explode functionality that separates different components of the object to individually see each piece of a larger object.

FIG. 3 is a flowchart of an example process for performing a virtual reality simulation. For convenience, the process 300 will be described as being performed by a system including one or more computers located in one or more locations. For example, a system for running analytics, models, and tests on digital representations of physical objects, e.g., the digital double platform 100 of FIG. 1, appropriately programmed, can perform the process 300.

The system receives sensor data from a real world object (step 302). In some cases, the real world object may be a prototype of a product that is currently under development. As a specific example, the real world object may be a driver seat of an automobile. In this example, automobile designers or manufacturers may be interested in designing and manufacturing a driver seat of an automobile with new or different characteristics that offer new or additional benefits to a driver of the automobile. For example, the automobile designers and manufacturers may wish to design and manufacture a driver seat that is more comfortable to sit in when a driver is handling the automobile, e.g., around sharp bends or corners.

In order to evaluate or test the current design of the product, sensors may be embedded or positioned on the prototype. The type of sensors embedded or positioned on the prototype is dependent on the type of product and the product characteristics that are to be evaluated or tested. For example, the sensors may include pressure and motion sensors that are positioned at various locations on a driver seat, including positions of the driver seat that come into direct contact with a driver when the driver sits in the seat. In other examples the sensors may include temperature sensors, light sensors, force sensing resistors, tactile sensors, flow measurement devices, chemical sensors, or altitude sensors.

In other cases, the real world object may be a simulator, e.g., a driving simulator. As a specific example, the real world object may be an automobile simulator. In this example, the automobile simulator may be used for novice driver training and testing, professional driver training and testing, training in critical driving conditions, testing the effects of impairment on driver performance, analysis of driver behavior and responses, or evaluating handling of controls in different conditions.

In order to perform such training or testing, sensors may be embedded or positioned on the simulator. The type of sensors embedded or positioned on the simulator is dependent on the specific simulator and tasks to be trained or tested. For example, the sensors may include pressure and motion sensors that are positioned on the driving seat, steering wheel, gear stick, brake and accelerator pedals, or other interior components of the automobile simulator. As in the previous example, the sensors may further include temperature sensors, light sensors, force sensing resistors, tactile sensors, flow measurement devices, chemical sensors, or altitude sensors. In some cases the sensors can include gaze tracking devices.

The sensor data received by the system may include dynamic data collected during a simulation using the real world object. For example, in order to test one or more characteristics of the real world object, the object may undergo one or more simulations that imitate the operation of the object over time. In some cases, a simulation may include a physical simulation where the object is subjected to conditions that imitate a real world use case of the object. For example, a physical simulation using a driver seat of an automobile may include subjecting the driver seat to forces or temperatures that imitate those experienced by the driver seat when it is installed in an automobile. As another example, a physical simulation using an automobile simulator may include subjecting the automobile to movements, forces or temperatures that imitate those experienced by the automobile when it is being driven.

The physical simulation may include virtual reality or mixed reality aspects. For example, in some cases the simulation may include an interactive simulation, i.e., a simulation that includes a human operator. In this example, virtual reality or mixed reality may be used to enhance the simulation, i.e., to make the simulation more realistic to the human operator. For example, an interactive simulation using a driver seat of an automobile or an automobile simulator may include positioning the human operator in the driver seat and immersing the human operator in a virtual reality or mixed reality environment that provides the human operator with a realistic driving experience, e.g., through the use of a virtual reality headset or a screen positioned in front of the driver seat or automobile.

The type of simulation performed is dependent on the type of real world object, the objectives of the product development process or training process, and characteristics to be tested. For example, in cases where an automobile designer wishes to design a driver seat that is more comfortable to sit in when a driver handling the automobile, e.g., around sharp bends or corners, the simulation may include an interactive simulation whereby a human operator simulates driving an automobile from the driver seat around multiple sharp bends or corners. As another example, in cases where a automobile simulator is to be used to test or train a human operator's ability to drive a police car in critical conditions, such as in pursuit of a suspect, the simulation may include an interactive simulation whereby a human operator simulates driving the automobile at high speed.

The system receives data representing a digital version of the real world object (step 304). In some implementations the digital version of the real world object may include a three-dimensional image, e.g., a holographic image, of the object. For example, the system may receive data representing a digital version of the driver seat of an automobile or of an automobile simulator.

In some implementations the digital version of the real world object may be a polygonal representation of the real world object. In other implementations the digital version of the real world object may be a partially or fully rendered version, e.g., a digital version including one or more visible features such as shading, texture-mapping, shadows, reflections, or bump-mapping. The type of digital version of the real world object and properties of the digital version of the real world object depend on the type of real world object, the objectives of the product development or training process, characteristics to be tested and the type of simulation performed. For example, in some cases it may be beneficial to include several visible features whereas in other cases, too many visible features may be obstructive. In some cases the digital version of the real world object may further include a digital version of the human operator, e.g., a digital version of the human operator sitting in a driver seat.

Step 304, i.e., receiving data representing a digital version of the real world object can come before, after or substantially at the same time as step 302, i.e., receiving sensor data from real world object.

The system performs a virtual reality simulation displaying (i) a representation of at least some of the sensor data, and (ii) the digital version of the real world object (step 306). In some implementations, performing the virtual reality simulation may include overlaying a visual representation of some or all of the sensor data on a visual representation of the digital version of the real world object. For example, in some implementations a visual representation of sensor data from each of a particular type of sensor, e.g., from pressure sensors only, may be overlaid on the visual representation of the digital version of the real world object.

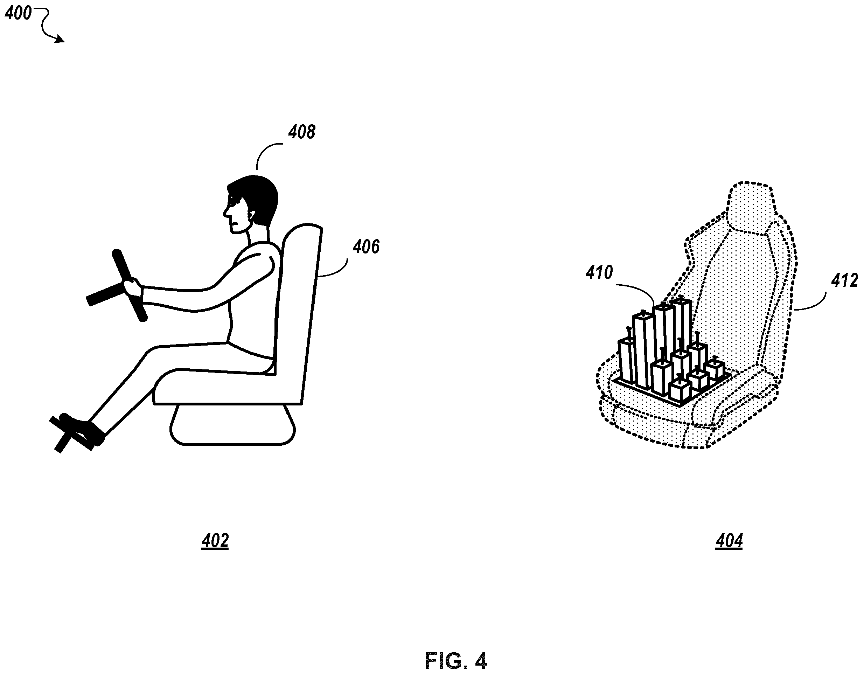

Visual representations of sensor data may include graphical representations of the sensor data, e.g., a bar chart with each bar corresponding to a respective sensor location and the length of each bar indicating a strength of the data signal. Other example visual representations of sensor data may include coloured representations of the sensor data, e.g., shading of the digital version of the real world object with a darker shade indicating areas of stronger data signals. Other example visual representations of sensor data may include dots indicating a tracked user's gaze direction at regular intervals, e.g., every second. Images of an example virtual reality simulation displaying a representation of sensor data and a digital version of a real world object are shown below with reference to FIG. 4.

In some implementations the system may aggregate sensor data from a first real world object and a second real world object, or aggregate multiple batches of sensor data from a same real world object, and perform a virtual reality simulation using (i) some or all of the aggregated sensor data, and (ii) the data representing the digital version of the real world object. For example, the system may perform the step 302 described above for multiple driver seats, multiple automobile simulators, or multiple batches of sensor data from a same driver seat or automobile simulator. Sensor data corresponding to each of the multiple driver seats, automobile simulators or different batches of sensor data may then be received by the system and aggregated. In some cases performing a virtual reality simulation using some or all of the aggregated sensor data may include performing a virtual reality simulation using determined averages over the sensor data. For example, each of the multiple objects may include a sensor positioned at a same location, e.g., a lumbar region of a driver seat. Sensor data gathered from each of the sensors positioned at these locations may be aggregated and then averaged, e.g., to determine average pressure readings in the lumbar region over all of the multiple driver seats. The averaged sensor data may then be used to perform a virtual reality simulation, as described above with reference to step 306.

In some implementations the system may further determine one or more modifications to the real world object based on the performed virtual reality simulation. For example, the performed virtual reality simulation may be analyzed to identify one or more areas in which the design of the real world object could be improved.

In other implementations the system may further generate feedback data outputs indicating how the human operator can improve operation of the real world object, e.g., how a driver can improve their driving. For example, the performed virtual reality simulation may show a high density of dots at a position on the windscreen directly in front of the driver seat and only one or two dots in the rear view mirror or wing mirrors. In response thereto, the system may generate feedback data indicating that a user does not use their rear view mirror or wing mirrors regularly enough.

In some implementations the system may use the performed virtual reality simulation to train or personalize an advanced driver assistance system. Based on the sensor information, gaze direction, and other data points in the VR simulation, the system can gather a user data within the VR environment. This user data can be fed into the analytics platform. Then, user habits and preferences can be predicted based on the outputs of this platform. The results can be used in a real world car to enhance an advanced driver assistance system.

FIG. 4 illustrates an example virtual reality simulation process 400. At stage 402, sensor data is collected from a real world object. For example, in the example simulation process 400, sensor data is collected from sensors positioned on a car driver seat 406. Sensor data may be collected from the sensors during a driving simulation, e.g., a simulation performed whilst a driver 408 is sitting in the driver seat 406.

At stage 404, a virtual reality simulation displaying a representation of at least some of the sensor data and a digital version of the real world object is performed. For example, in the example simulation process 400, the virtual reality simulation overlays a histogram representation 410 of sensor data collected from one or more pressure sensors on a digital representation 412 of the driver seat 406. The histogram representation shows that the driver seat experienced higher levels of pressure in the middle of the lower portion of the driver seat and at the lumbar region of the driver seat.

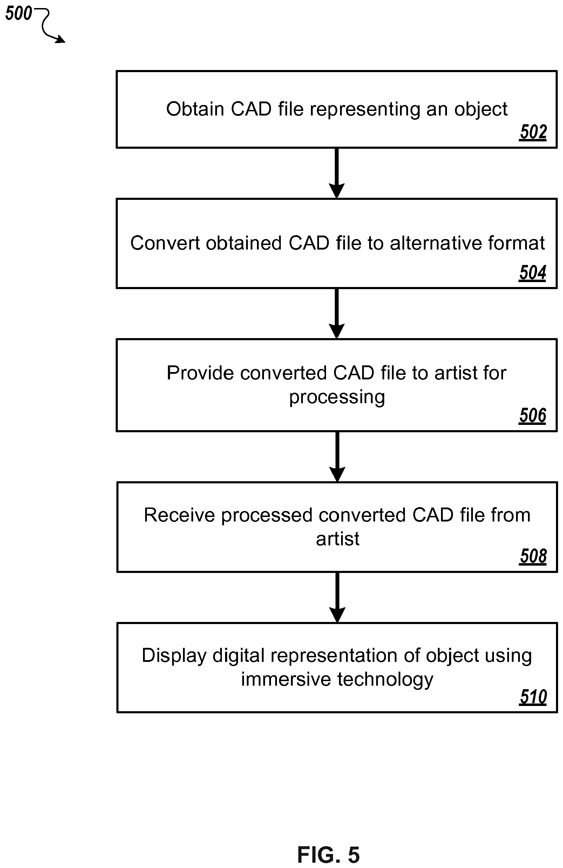

FIG. 5 is a flowchart of an example process 500 for converting the format of a computer-aided design (CAD) file. For convenience, the process 500 will be described as being performed by a system including one or more computers located in one or more locations. For example, a CAD conversion pipeline, e.g., the CAD converter 104 of FIG. 1, appropriately programmed, can perform the process 500.

The system obtains a computer aided design (CAD) file representing an object (step 502). In some implementations the CAD file may include a parametric model of the object, e.g., a representation of the object whereby parameters and constraints are used to determine the size, shape, and other properties of the elements of the object.

The system converts the obtained CAD file to an alternative format (step 504). The converted CAD file includes a polygon mesh representation of the object. In some implementations, converting the obtained CAD file to an alternative format may include converting the obtained CAD file using computer graphics software for automatic three-dimensional optimization, e.g., simplygon.

The system provides the converted CAD file to an artist for processing (step 506). Processing the converted CAD file may include visually enhancing to the object represented by the converted CAD file, e.g., to make the object appear more realistic. In some implementations, providing the converted CAD file to an artist for processing may include providing the converted CAD file to a task management system. The task management system may receive the file including a polygon mesh representation of the object, and automatically provide the received file to an available artist for processing. The task management system may then receive a processed file from the available artist.

The system receives a processed converted CAD file from the artist (step 508). The processed converted CAD file includes a digital representation of the object. For example, the digital representation of the object may include a three-dimensional image or hologram representing the object.

In some implementations, the system may further process the digital representation of the object using one or more reusable scripts. The one or more reusable scripts include scripts that may be used to help incorporate different features into digital representations outputted from the system. Example features include a manipulation functionality that allows a viewer of a digital representation of an object to rotate and zoom in on all or portions of the digital representation of the object, or an explode functionality that separates different components of the digital representation of the object to see each piece of a larger digital representation individually. For example, a digital representation of an automobile may be provided with a manipulation functionality that allows a viewer of the digital representation to zoom in on portions of the automobile, e.g., the wheels. The digital representation of the automobile may further be provided with an explode functionality that enables the viewer of the digital representation to separately view different components of the automobile, e.g., the driver seat and dashboard.

The system displays the digital representation of the object using immersive technology software (step 510). Example types of immersive technology software include (i) virtual reality software, (ii) mixed reality software, or (iii) artificial intelligence software. For example, the system may display the digital representation of the object as part of a virtual reality simulation, as described above with reference to FIG. 3.

Embodiments and all of the functional operations described in this specification may be implemented in digital electronic circuitry, or in computer software, firmware, or hardware, including the structures disclosed in this specification and their structural equivalents, or in combinations of one or more of them. Embodiments may be implemented as one or more computer program products, *i.e.,* one or more modules of computer program instructions encoded on a computer readable medium for execution by, or to control the operation of, data processing apparatus. The computer readable medium may be a machine-readable storage device, a machine-readable storage substrate, a memory device, a composition of matter effecting a machine-readable propagated signal, or a combination of one or more of them. The term "data processing apparatus" encompasses all apparatus, devices, and machines for processing data, including by way of example a programmable processor, a computer, or multiple processors or computers. The apparatus may include, in addition to hardware, code that creates an execution environment for the computer program in question, e.g., code that constitutes processor firmware, a protocol stack, a database management system, an operating system, or a combination of one or more of them. A propagated signal is an artificially generated signal, *e.g.,* a machine-generated electrical, optical, or electromagnetic signal that is generated to encode information for transmission to suitable receiver apparatus.

A computer program (also known as a program, software, software application, script, or code) may be written in any form of programming language, including compiled or interpreted languages, and it may be deployed in any form, including as a stand-alone program or as a module, component, subroutine, or other unit suitable for use in a computing environment. A computer program does not necessarily correspond to a file in a file system. A program may be stored in a portion of a file that holds other programs or data (*e.g.,* one or more scripts stored in a markup language document), in a single file dedicated to the program in question, or in multiple coordinated files (*e.g.,* files that store one or more modules, sub programs, or portions of code). A computer program may be deployed to be executed on one computer or on multiple computers that are located at one site or distributed across multiple sites and interconnected by a communication network.

The processes and logic flows described in this specification may be performed by one or more programmable processors executing one or more computer programs to perform functions by operating on input data and generating output. The processes and logic flows may also be performed by, and apparatus may also be implemented as, special purpose logic circuitry, *e.g.,* an FPGA (field programmable gate array) or an ASIC (application specific integrated circuit).

Processors suitable for the execution of a computer program include, by way of example, both general and special purpose microprocessors, and any one or more processors of any kind of digital computer. Generally, a processor will receive instructions and data from a read only memory or a random access memory or both.

The essential elements of a computer are a processor for performing instructions and one or more memory devices for storing instructions and data. Generally, a computer will also include, or be operatively coupled to receive data from or transfer data to, or both, one or more mass storage devices for storing data, e.g., magnetic, magneto optical disks, or optical disks. However, a computer need not have such devices. Moreover, a computer may be embedded in another device, *e.g.,* a tablet computer, a mobile telephone, a personal digital assistant (PDA), a mobile audio player, a Global Positioning System (GPS) receiver, to name just a few. Computer readable media suitable for storing computer program instructions and data include all forms of non-volatile memory, media and memory devices, including by way of example semiconductor memory devices, *e.g.,* EPROM, EEPROM, and flash memory devices; magnetic disks, *e.g.,* internal hard disks or removable disks; magneto optical disks; and CD ROM and DVD-ROM disks. The processor and the memory may be supplemented by, or incorporated in, special purpose logic circuitry.

To provide for interaction with a user, embodiments may be implemented on a computer having a display device, *e.g.,* a CRT (cathode ray tube) or LCD (liquid crystal display) monitor, for displaying information to the user and a keyboard and a pointing device, *e.g.,* a mouse or a trackball, by which the user may provide input to the computer. Other kinds of devices may be used to provide for interaction with a user as well; for example, feedback provided to the user may be any form of sensory feedback, e.g., visual feedback, auditory feedback, or tactile feedback; and input from the user may be received in any form, including acoustic, speech, or tactile input.

Embodiments may be implemented in a computing system that includes a back end component, *e.g.,* as a data server, or that includes a middleware component, *e.g.,* an application server, or that includes a front end component, e.g., a client computer having a graphical user interface or a Web browser through which a user may interact with an implementation, or any combination of one or more such back end, middleware, or front end components. The components of the system may be interconnected by any form or medium of digital data communication, *e.g.*, a communication network. Examples of communication networks include a local area network ("LAN") and a wide area network ("WAN"), *e.g.*, the Internet.

The computing system may include clients and servers. A client and server are generally remote from each other and typically interact through a communication network. The relationship of client and server arises by virtue of computer programs running on the respective computers and having a client-server relationship to each other.

While this specification contains many specifics, these should not be construed as limitations on the scope of the disclosure or of what may be claimed, but rather as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems may generally be integrated together in a single software product or packaged into multiple software products.

In each instance where an HTML file is mentioned, other file types or formats may be substituted. For instance, an HTML file may be replaced by an XML, JSON, plain text, or other types of files. Moreover, where a table or hash table is mentioned, other data structures (such as spreadsheets, relational databases, or structured files) may be used.

Thus, particular embodiments have been described. Other embodiments are within the scope of the following claims. For example, the actions recited in the claims may be performed in a different order and still achieve desirable results.

## Claims

1. A computer-implemented method comprising:
receiving sensor data from a real world object;
receiving data representing a digital version of the real world object; and
performing a virtual reality simulation displaying (i) a representation of at least some of the sensor data, and (ii) the digital version of the real world object.

2. The method of claim 1, wherein the sensor data comprises data from one or more sensors positioned on the real world object and optionally the sensors comprise one or more of pressure, temperature, motion, or gaze tracking sensors.

3. The method of claim 1 or 2, wherein the sensor data comprises dynamic data collected during a physical simulation using the real world object.

4. The method of claim 3, wherein the physical simulation comprises an interactive virtual reality or mixed reality simulation.

5. The method of any of the preceding claims, wherein the digital version of the real world object comprises a three-dimensional image of the object, and optionally the three-dimensional image comprises a polygonal three-dimensional image.

6. The method of any of the preceding claims, wherein performing a virtual reality simulation using (i) the sensor data, and (ii) the data representing the digital version of the real world object comprises overlaying a visual representation of some or all of the sensor data on a visual representation of the digital version of the real world object.

7. The method of claim 6, wherein the visual representation of some or all of the sensor data comprises one or more of (i) a graphical representation, and (ii) a colour representation of some or all of the sensor data; and/or wherein overlaying a visual representation of some or all of the sensor data on a visual representation of the digital version of the real world object comprises overlaying a visual representation of sensor data from sensors of a given type on a visual representation of the digital version of the real world object.

8. The method of any of the preceding claims, further comprising determining one or more modifications to the real world object based on the performed virtual reality simulation.

9. The method of any of the preceding claims, wherein the real world object comprises a driver simulator, and wherein the method further comprises:
generating feedback data outputs indicating how a user of the driving simulator can improve their driving; and/or
using the performed virtual reality simulation to train or personalize an advanced driver assistance system.

10. The method of any of the preceding claims, further comprising:
aggregating sensor data from a first real world object and a second real world object; and
performing a virtual reality simulation using (i) some or all of the aggregated sensor data, and (ii) the data representing the digital version of the real world object.

11. The method of any of the preceding claims, further comprising:
aggregating batches of sensor data from the real world object, wherein each batch of sensor data corresponds to respective data collected during a physical simulation using the real world object; and
performing a virtual reality simulation using (i) some or all of the aggregated sensor data, and (ii) the data representing the digital version of the real world object.

12. The method of any of the preceding claims, wherein performing the virtual reality simulation further comprises displaying the digital version of the real world object in the same field of view as the real world object itself or another recording of the real world object.

13. The method of any of the preceding claims, wherein the data representing a digital version of the real world object comprises data generated using crowd guided assistance.

14. A system comprising:
one or more computers and one or more storage devices on which are stored instructions that are operable, when executed by the one or more computers, to cause the one or more computers to perform operations comprising:
receiving sensor data from a real world object;
receiving data representing a digital version of the real world object; and
performing a virtual reality simulation displaying (i) a representation of at least some of the sensor data, and (ii) the digital version of the real world object.

15. The system of claim 14, wherein the one or more computers and one or more storage devices on which are stored instructions that are operable, when executed by the one or more computers, to cause the one or more computers to perform operations defined in one or more of claims 2 to 13.
